(19) Europäisches Patentamt
European Patent Office
Office européen des brevets

(11) **EP 2 954 338 B1**

(12) **EUROPÄISCHE PATENTSCHRIFT**

(45) Veröffentlichungstag und Bekanntmachung des Hinweises auf die Patenterteilung:
**15.04.2020  Patentblatt 2020/16**

(21) Anmeldenummer: **14703032.4**

(22) Anmeldetag: **05.02.2014**

(51) Int Cl.:
*G01R 31/315* (2006.01)          *G01R 31/28* (2006.01)
*H04B 5/00* (2006.01)            *H04B 17/16* (2015.01)

(86) Internationale Anmeldenummer:
**PCT/EP2014/000311**

(87) Internationale Veröffentlichungsnummer:
**WO 2014/121928 (14.08.2014 Gazette 2014/33)**

(54) **VERFAHREN UND VORRICHTUNG ZUM PRÜFEN EINES SCHALTKREISES**

METHOD AND DEVICE FOR TESTING A CIRCUIT

PROCÉDÉ ET DISPOSITIF POUR TESTER UN CIRCUIT DE COMMUTATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.02.2013   DE 102013002139**
**07.02.2013   DE 102013002140**

(43) Veröffentlichungstag der Anmeldung:
**16.12.2015   Patentblatt 2015/51**

(73) Patentinhaber: **Giesecke+Devrient Mobile Security GmbH**
**81677 München (DE)**

(72) Erfinder:
• **FINKENZELLER, Klaus**
**85774 Unterföhring (DE)**
• **BALDISCHWEILER, Michael**
**81825 München (DE)**

(56) Entgegenhaltungen:
**WO-A1-2005/086279      DE-A1- 10 117 249**
**US-A- 3 659 197          US-B1- 6 236 220**

• **Klaus Finkenzeller: "FUNDAMENTALS AND APPLICATIONS IN CONTACTLESS SMART CARDS, RADIO FREQUENCY IDENTIFICATION AND NEAR-FIELD COMMUNICATION, THIRD EDITION" In: "FUNDAMENTALS AND APPLICATIONS IN CONTACTLESS SMART CARDS, RADIO FREQUENCY IDENTIFICATION AND NEAR-FIELD COMMUNICATION, THIRD EDITION", 1 January 2010 (2010-01-01), WILEY, XP055522592, ISBN: 978-0-470-69506-7 pages 263-266,**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft ein Verfahren und eine Messvorrichtung zum Prüfen eines zur kontaktlosen Datenkommunikation eingerichteten Schaltkreises, welcher eine Antenne und ein mit der Antenne gekoppeltes elektronisches Bauteil umfasst.

Das Prüfen des Schaltkreises kann dabei sowohl elektronische Eigenschaften des Schaltkreises als auch die Funktionsfähigkeit des Schaltkreises oder einzelner Komponenten des Schaltkreises betreffen.

Portable Datenträger, wie beispielsweise ein Personalausweis, ein Reisepass, eine Kreditkarte, ein Label zur Warensicherung oder dergleichen, können mit einer Antenne, beispielsweise in Form einer Antennenspule, zur kontaktlosen Datenkommunikation mit einem Lesegerät ausgestattet sein. Die Antennenspule ist dazu in der Regel mit einem elektronischen Bauteil des Datenträgers, insbesondere einem Chip, verbunden und auf einer Träger- oder Inlayschicht, beispielsweise aus einem Kunststoffmaterial wie PC oder PVC, eines Datenträgerkörpers des Datenträgers aufgebracht, beispielsweise aufgedruckt.

Alternativ kann ein entsprechender Schaltkreis auch eingerichtet sein, in ein Endgerät integriert zu werden, wie beispielsweise ein Mobilfunkendgerät, ein Smartphone oder ein Lesegerät. Der Schaltkreis kann insbesondere als RFID- oder NFC-Modul ausgebildet sein, welches vorgesehen ist, fest in ein Endgerät der genannten Art integriert zu werden.

Um die Funktionsfähigkeit einer Antennenspule während oder nach der Herstellung des entsprechenden Datenträgers oder Geräts zu prüfen, sind verschiedene Verfahren bekannt. Bei einer solchen Prüfung wird im Wesentlichen geprüft, ob die Antennenspule einen Bruch aufweist und/oder ob zwei oder mehr Spulenwindungen der Antenne versehentlich kurzgeschlossen sind. Mängel dieser Art beeinträchtigen die Funktionsfähigkeit der Antennenspule erheblich bzw. zerstören diese vollständig. Eine Prüfung des Schaltkreises, bestehend aus der Antenne und dem mit der Antenne verbundenen elektronischen Bauteil, kann, wie bereits erwähnt, auch die Funktionsfähigkeit des Bauteils oder einzelner Komponenten des Bauteils betreffen.

Produktionsbegleitend erfolgt bisher zumeist eine Prüfung der Antennenspule in Form einer Gleichstrom-Widerstandsmessung. Ein solches Prüfverfahren ist aufwendig, da eine Kontaktierung der Antennenspule erforderlich ist. Weiterhin können nur bestimmte Fehler des geprüften Schaltkreises erkannt werden. Eine Fehlfunktion eines oder mehrerer Komponenten des elektronischen Bauteils oder ein Leiterbahnbruch in bestimmten Bereichen der Antenne sind auf diese Weise nicht oder kaum erkennbar.

Alternativ können die Resonanzfrequenz der Antennenspule und deren Güte kontaktlos bestimmt werden. Dazu wird in der Regel ein Phasen- und Impedanz-Analysator verwendet. Ein solches, sehr aufwendiges Verfahren ist detailliert beispielsweise im "RFID-Handbuch" von Klaus Finkenzeller, 6. Auflage, Carl Hanser Verlag, München, 2012, in Kapitel 4.1.11.2, beschrieben. Liegt die gemessene Resonanzfrequenz in einem vorgegebenen Bereich, so ist die Antennenspule funktionsfähig. Diese Art der Prüfung ist aussagekräftiger als eine rein ohmsche Messung, allerdings ungleich aufwendiger und am besten manuell durchzuführen. Die Zeitdauer einer solchen Prüfung liegt im Bereich von mehreren Sekunden. Daher wird diese Prüfung in der Regel nicht produktionsbegleitend durchgeführt, sondern lediglich an einigen Stichproben und für die Produktionsfreigabe. Weiterhin können Eigenschaften des Analysators, beispielsweise die Impedanz einer Messantenne, das Ergebnis der Messung beeinflussen. Verschiedene Analysatoren führen daher in der Regel zu abweichenden Messergebnissen.

Weiterer Stand der Technik findet sich in dem Buch "Fundamentals and applications of smart cards, radio frequency identification and near-field communication, third edition" ebenfalls von Klaus Finkenzeller in Kapitel 9.2.4. sowie den Patentanmeldungen US6236220, DE10117249 und US3659197.

Aufgabe der vorliegenden Erfindung ist es demnach, ein Verfahren und eine Messvorrichtung zur schnellen, einfach durchzuführenden, kostengünstigen und reproduzierbaren Prüfung eines Schaltkreises, insbesondere hinsichtlich dessen Eigenresonanzfrequenz und/oder Güte, vorzuschlagen.

Diese Aufgabe wird durch ein Verfahren und eine Messvorrichtung mit den Merkmalen der unabhängigen Ansprüche gelöst. Vorteilhafte Ausgestaltungen und Weiterbildungen der Erfindung sind in den abhängigen Ansprüchen angegeben.

Ein Grundgedanke der vorliegenden Erfindung besteht darin, den zu prüfenden Schaltkreis mittels eines Energiepulses zur Schwingung anzuregen und die durch die Anregung erzeugte Schwingung des Schaltkreises zu erfassen und auszuwerten. Aus der erfassten Schwingung können dann, wie nachfolgend im Detail beschrieben, Eigenschaften des Schaltkreises bestimmt werden, wie beispielsweise die Eigenresonanzfrequenz oder die Güte des Schaltkreises.

Die vorliegende Erfindung basiert weiterhin auf der Erkenntnis, dass elektrische Eigenschaften eines zu prüfenden Schaltkreises, insbesondere die Eigenresonanzfrequenz und die Güte des Schaltkreises, abhängig sind von der Feldstärke eines magnetischen Wechselfeldes, in dem sich der Schaltkreis während oder kurz vor der Messung, d.h. der Anregung durch den Energiepuls, befindet. Da bekannte Verfahren diese Einflussgröße bisher unbeachtet gelassen haben, waren genaue und reproduzierbare Messungen entsprechender Eigenschaften nicht möglich.

Ein Grund für die Feldstärkeabhängigkeit der Resonanzfrequenz und der Güte eines Transponders, welcher hier beispielhaft als zu prüfender elektronischer Schaltkreis angenommen wird, liegt in den physikalischen Eigenschaften elektronischer Komponenten des Transponders. Zur Gewinnung einer Versorgungsspannung eines Transponderchips ist die Transponderantenne mit einem Gleichrichterbauteil verbunden. Die von der Transponderantenne gesehene Impedanz des Gleichrichters hängt dabei von dem Strom ab, welcher in den Gleichrichter fließt. Weitere Einflussgrößen sind spannungsabhängige Sperrschichtkapazitäten des Gleichrichterbauteils sowie gegebenenfalls Transistorbauteile auf dem Transponderchip, der dynamische Gleich- und Wechselstromwiderstand des Gleichrichterbauteils sowie eine daraus resultierende Eingangskapazität des Transponderchips. Mit anderen Worten, die Resonanzfrequenz des Transponders hängt indirekt aus den genannten Gründen von einem magnetischen Wechselfeld ab, in dem sich der Transponder während der Messung befindet.

Ein erfindungsgemäßes Verfahren zum Prüfen eines zur kontaktlosen Datenkommunikation eingerichteten Schaltkreises, welcher eine Antenne und ein mit der Antenne gekoppeltes elektronisches Bauteil umfasst, umfasst daher die folgenden Schritte:
Der elektronische Schaltkreis wird mittels eines Energiepulses angeregt. In einem weiteren Schritt wird eine Schwingung des Schaltkreises in Antwort auf die Anregung des Schaltkreises durch den Energiepuls erfasst. Die erfasste Schwingung des Schaltkreises wird schließlich ausgewertet, insbesondere hinsichtlich einer Eigenresonanzfrequenz des Schaltkreises.

Das erfindungsgemäße Verfahren zeichnet sich unter anderem dadurch aus, dass das Auswerten der erfassten Schwingung in Abhängigkeit von der Feldstärke eines magnetischen Wechselfeldes erfolgt, in welchem der Schaltkreis angeordnet ist.

Das Auswerten der erfassten Schwingung kann insbesondere in Abhängigkeit eines durch das Vorliegen des magnetischen Wechselfeldes bedingten Betriebs- oder Schaltungszustandes einer oder mehrerer Komponenten des elektronischen Bauteils erfolgen. Die angesprochenen Betriebs- oder Schaltungszustände können beispielsweise die Ladung eines Kondensators betreffen oder den Stromfluss durch ein Gleichrichter-Bauteil.

Eine konkrete Ausführungsform des erfindungsgemäßen Verfahrens umfasst demnach die weiteren Schritte des Erzeugens eines magnetischen Wechselfeldes, vorzugsweise konstanter bzw. vorgegebener Feldstärke, und des Anordnens des Schaltkreises in dem Wechselfeld. Die beiden Schritte werden dabei vor dem Schritt des Anregens des Schaltkreises mittels des Energiepulses durchgeführt.

Der Schaltkreis ist zumindest während des Anregens in dem erzeugten magnetischen Wechselfeld angeordnet. Das Wechselfeld bleibt also eingeschaltet. Insbesondere ist der Schaltkreis bereits vor dem Anregen und zumindest während des Erfassens in dem erzeugten magnetischen Wechselfeld angeordnet. Bevorzugt wird - vor dem Anregen oder nach dem Erfassen der Schwingung des Schaltkreises in Antwort auf die Anregung - die Schwingung des Schaltkreises im Wechselfeld ohne Anregung erfasst.

In der Regel erfolgt das Anregen des Schaltkreises als induktives Anregen mittels eines gepulsten Magnetfeldes. Dieses Magnetfeld ist dabei nicht mit dem vorstehend genannten magnetischen Wechselfeld zu verwechseln. Das Magnetfeld, welches im Schritt des Anregens des Schaltkreises erzeugt wird, wird dabei vorzugsweise durch einen einzelnen Strompuls erzeugt. Der Strompuls kann dabei vorzugsweise als Gleichstrompuls in Form eines Dirac-Stoßes erzeugt werden. Alternativ kann auch ein Strompuls erzeugt werden, der lediglich eine steile Flanke aufweist.

Vorzugsweise erfolgt das Anregen des Schaltkreises kontaktlos mittels einer externen Erregerspule. Das Erfassen der Schwingung des Schaltkreises hingegen erfolgt ebenfalls vorzugsweise kontaktlos mittels einer externen Messantenne. Erregerspule und Messantenne werden dabei vorzugsweise in unmittelbarer Nähe des zu prüfenden Schaltkreises angeordnet.
Weiterhin werden Messantenne und Erregerspule dabei, wie nachstehend in Detail beschrieben, vorzugsweise orthogonal zueinander angeordnet.
Die Antenne des Schaltkreises ist vorzugsweise eine induktiv koppelnde Antenne, insbesondere also eine RFID- oder NFC-Antennenspule. Insbesondere kann die Antenne eine Antennenspule mit mindestens einer Leiterschleife sein.

Das magnetische Wechselfeld kann mittels einer Sendeantenne erzeugt werden. Weiterhin kann vorgesehen sein, die Feldstärke des Wechselfeldes in einem vorgegebenen Bereich mittels einer Kalibrierantenne zu messen, um ein Erzeugen des Wechselfeldes gemäß der vorgegebenen Feldstärke in präziser und nachprüfbarer Weise zu ermöglichen.

Die Kalibrierantenne und die Antenne des zu prüfenden Schaltkreises werden dabei vorzugsweise derart relativ zur Sendeantenne angeordnet, dass im Bereich der Kalibrierantenne und im Bereich der Antenne des Schaltkreises jeweils ein magnetisches Wechselfeld der gleichen Feldstärke vorliegt. Auf diese Weise wird es ermöglicht, dass die Prüfung des Schaltkreises in einer genau vorgebbaren, standardisierten Umgebung, d.h. bei einem in vorgegebener Feldstärke vorliegenden magnetischen Wechselfeld, durchgeführt werden kann. Dies erlaubt erstmals eine sehr präzise und reproduzierbare Messung der entsprechenden physikalischen Eigenschaften des Schaltkreises, insbesondere der Resonanzfrequenz und der Güte des Schaltkreises.

Ein alternativer Weg der Kalibrierung ist es, die Kalibrierantenne - wie später den Schaltkreis - zu vermessen und eine von der Feldstärke abhängige Eigenschaft der Kalibrierantenne zu bestimmen. Die erzeugte Feldstärke wird so eingestellt, dass die gemessene Eigenschaft der Kalibrierantenne einen vorgegebenen Wert für diese Eigenschaft einnimmt. Somit entspricht die erzeugte Feldstärke der vorgegebenen Feldstärke. Für die Kalibrierantenne(nspule) werden also die Schritte des zusätzlichen Anregens mit einem Impuls, des Erfassens der daraus resultierenden Schwingung und des Bestimmens der Eigenschaft im Rahmen des Auswertens der erfassten Schwingung ausgeführt. Diese Messung der Eigenschaft der Kalibrierantenne wird bei angepasster Feldstärke solange wiederholt, bis die Messung den vorgegebenen Eigenschaftswert der Kalibrierantenne ergibt.

Das magnetische Wechselfeld wird dabei derart erzeugt, dass der darin angeordnete Schaltkreis in eine bezüglich Amplitude und Frequenz konstante sinusförmige Schwingung versetzt wird. Die Frequenz entspricht dabei vorzugsweise einer Betriebsfrequenz des Schaltkreises. Im Falle einer kontaktlos kommunizierenden Chipkarte kann dies beispielsweise eine Frequenz von 13,56 MHz sein.

Gemäß einer bevorzugten Ausführungsform des erfindungsgemäßen Verfahrens wird der Schaltkreis, wie beschrieben, im Bereich des magnetischen Wechselfeldes angeordnet und das Wechselfeld liegt zum Zeitpunkt des Anregens des Schaltkreises mittels des Energiepulses in konstanter Weise vor. Mit anderen Worten, das Anregen des Schaltkreises durch den Energiepuls erfolgt bei dauerhaft angeschaltetem magnetischen Wechselfeld. Beim Auswerten der erfassten Schwingung wird dann derjenige Anteil der erfassten Schwingung berücksichtigt, welcher durch das Wechselfeld hervorgerufen wird. Dabei handelt es sich um die vorstehend erwähnte, konstante sinusförmige Schwingung.

Im Rahmen dieser Ausführungsform umfasst das Erfassen der Schwingung des Schaltkreises ein Erfassen einer Überlagerung einer durch das Wechselfeld hervorgerufenen sinusförmigen Schwingung des Schaltkreises mit einer freien, gedämpften Schwingung des Schaltkreises, welche aus der Anregung des Schaltkreises durch den Energiepuls resultiert.

Das Auswerten der erfassten Schwingung des Schaltkreises kann mittels einer Subtraktion der konstanten sinusförmigen Schwingung von der erfassten Schwingung erfolgen. Auf diese Weise kann die freie, gedämpfte Schwingung ermittelt werden.

Um eine solche Vorgehensweise zu unterstützen, kann die sinusförmige Schwingung vor dem Anregen durch den Energiepuls, oder in hinreichendem Abstand nach dem Anregen, d.h. wenn die freie, gedämpfte Schwingung bereits ausgeklungen ist, erfasst und hinsichtlich Amplitude, Phase und Frequenz ermittelt und in einer Auswertungseinrichtung gespeichert werden.

Die Subtraktion der konstanten sinusförmigen Schwingung von der erfassten Schwingung des Schaltkreises kann mittels Software oder mittels Hardware erfolgen. In der Hardwarevariante kann ein Verstärker verwendet werden. Die beschriebene Subtraktion kann dann vorzugsweise durch Addition eines Signals erfolgen, welches dem von der Kalibrierantenne erfassten und dann invertierten Signal entspricht, d.h. durch Addition der invertierten Sinusschwingung.

Ein durch einen Energiepuls angeregter Schaltkreis schwingt nach der Anregung grundsätzlich unmittelbar mit einer freien, gedämpften Schwingung A(t) aus, welche mit der folgenden Formel beschrieben werden kann:

$$A(t) = A_0(t)\, e^{\,(-\delta t)} \cos \omega t.$$

A(t) kann dabei dem Strom I oder der Spannung U eines durch den Schaltkreis gebildeten elektrischen Schwingkreises entsprechen. Demnach kann der Spannungsverlauf des Schaltkreises unmittelbar nach der Anregung mit der folgenden Formel beschrieben werden:

$$U(t) = U_0(t)\, e^{\,(-\delta t)} \cos \omega t$$

Die Kreisfrequenz $\omega$ entspricht dabei der Eigenresonanzfrequenz des Schaltkreises fres multipliziert mit $2\,\pi$ ($\omega = 2\,\pi\, f_{res}$). Aus dem Abklingkoeffizienten $\delta$ und der Eigenresonanzfrequenz $f_{res}$ kann die Güte Q des Schaltkreises ermittelt werden. Alternativ kann die Güte Q auch aus zwei aufeinander folgenden Maxima An und $A_{n+1}$ der Schwingungsamplitude des Schaltkreises ermittelt werden.

$$Q = \frac{\pi * f_{res}}{\delta} = \frac{\pi}{\ln\left(\dfrac{A_n}{A_{n+1}}\right)}$$

Je länger der Abklingvorgang dauert, desto höher ist die Güte des entsprechenden Schwingkreises. D.h. eine Auswertung der freien, gedämpften Schwingung des Schaltkreises, d. h. deren Ausschwingen unmittelbar nach der Anregung, erlaubt es, sowohl die Eigenresonanzfrequenz als auch die Güte des Schaltkreises zu bestimmen.

Ein Aspekt der vorliegenden Erfindung betrifft, wie erwähnt, eine präzise Messung der Eigenresonanzfrequenz des Schaltkreises unter vorgegebenen äußeren Bedingungen, d.h. in einem magnetischen Wechselfeld konstanter, vorgegebener Feldstärke. Dies erlaubt eine entsprechende Messung in reproduzierbarer Weise und insbesondere bei einer Betriebsfeldstärke des Schaltkreises.

Ein weiterer Aspekt der Erfindung beruht nun auf dem Umstand, dass ein Defekt der Antenne des zu prüfenden Schaltkreises, wie beispielsweise eine Unterbrechung einer Leiterbahn oder ein Kurzschluss zwischen einzelnen Spulenwindungen einer als Antennenspule ausgebildeten Antenne, dazu führt, dass sich ein bei einer beschriebenen Prüfung erkennbarer Signalverlauf des Ausschwingens signifikant von einem entsprechenden Signalverlauf des Ausschwingens einer intakten Antennenspule unterscheidet. Anhand der ausgewerteten freien, gedämpften Schwingung festgestellte Parameter einer fehlerhaften Antenne, insbesondere deren Eigenresonanzfrequenz und deren Güte, unterscheiden sich deutlich von den entsprechenden Parametern einer intakten Antenne.

Ein Leiterbahnbruch beispielsweise zeigt sich in einem deutlich erkennbar veränderten Ausschwingverhalten, insbesondere einer veränderten, in der Regel erhöhten Eigenresonanzfrequenz. Im Falle eines Kurzschlusses von zwei oder mehr Spulenwindungen ist kaum mehr ein Ausschwingen zu beobachten.

Auf diese Weise kann beim Auswerten der freien, gedämpften Schwingung durch die Prüfvorrichtung nicht nur erkannt werden, ob die Antennenspule fehlerhaft ist oder nicht, sondern es kann im Falle eines Fehlers oder Mangels auch der Typ des Fehlers bzw. die Art des Mangels festgestellt werden.

Ein dritter Aspekt der Erfindung betrifft schließlich die Tatsache, dass bei Vorliegen eines intakten Schaltkreises bei verschiedenen Feldstärken jeweils, wenn auch gegebenenfalls nur geringfügig, voneinander abweichende Resonanzfrequenzen ermittelt werden sollten. Mit anderen Worten, werden bei wiederholtem Durchführen des beschriebenen Verfahrens - bei jeweils verschiedenen Feldstärken des magnetischen Wechselfeldes - gleiche Resonanzfrequenzen ermittelt, so spricht dies für einen Defekt des elektronischen Bauteils bzw. solcher Elemente des Bauteils, welche grundsätzlich mit für eine Abhängigkeit der Resonanzfrequenz von der Feldstärke verantwortlich sind.

Die Vorteile des erfindungsgemäßen Verfahrens sind offensichtlich und zahlreich.

Erstmals kann die Resonanzfrequenz präzise und reproduzierbar, unter variabel, aber fest einstellbaren Bedingungen, ermittelt werden. Ein bisher nicht erfassbarer Einfluss eines magnetischen Wechselfeldes auf Messergebisse kann nun in präziser Weise vorgegeben und in der Messung berücksichtigt werden. Dies ermöglicht eine präzise Messung physikalischer Eigenschaften des Schaltkreises unter eindeutig reproduzierbaren Messbedingungen.

Weiter kann die Prüfung der Antenne kontaktlos und mit sehr geringem Zeitaufwand erfolgen. Dies erlaubt für geeignete Ausführungsformen, wie beispielsweise Chipkarten mit gedruckter Antennenspule, eine Prüfung während eines laufenden Produktionsprozesses. Insbesondere kann auch bereits eine gedruckte Antennenspule, welche noch nicht vollständig ausgehärtet ist, mit dem erfindungsgemäßen Verfahren geprüft werden. Die benötigte Messvorrichtung, welche nachfolgend noch im Detail beschrieben wird, ist vergleichsweise einfach und kostengünstig bereitzustellen. Zudem erlaubt das Verfahren nicht nur, physikalischen Eigenschaften des Schaltkreises in reproduzierbare Weise zu bestimmen, sowie Fehler oder Mängel einer defekten Antenne zu erkennen, sondern auch verschiedene Fehlertypen eines zu prüfenden Schaltkreises zu unterscheiden.

Gemäß einer Variante des erfindungsgemäßen Verfahrens kann der Schaltkreis im Bereich des magnetischen Wechselfeldes angeordnet werden und das Wechselfeld zum Zeitpunkt des Anregens des Schaltkreises mittels des Energiepulses abgeschaltet sein. Dabei erfolgt die Abschaltung des Wechselfeldes zeitlich erst derart kurz vor dem Anregen des Schaltkreises durch den Energiepuls, dass Einflüsse des zuvor vorliegenden, noch angeschalteten Wechselfeldes auf Betriebs- und Schaltungszustände einer oder mehrerer Komponenten des elektronischen Bauteils weiterhin vorliegen. D.h. der Schaltkreis ist zum Zeitpunkt des Anregens noch mit Energie versorgt. Mit anderen Worten, das magnetische Wechselfeld wird zumindest kurzzeitig abgeschaltet und das Anregen des Schaltkreises durch den Energiepuls erfolgt bei abgeschaltetem magnetischen Wechselfeld. Diese Variante hat den Vorteil, dass das Auswerten der erfassten Schwingung dadurch einfacher wird, dass kein der sinusförmigen Schwingung entsprechender Schwingungsanteil von dem erfassten Signal subtrahiert werden muss.

Wir erwähnt, wird das magnetische Wechselfeld vorzugsweise nur kurzfristig abgeschaltet. Die Dauer der Abschaltung des magnetischen Wechselfeldes ist dabei derart kurz, dass der zu prüfende Schaltkreis auch der Abschaltung des Wechselfeldes mit Energie versorgt bleibt. Vorzugsweise dauert das Abschalten nur wenige Mikrosekunden, bevorzugt etwa 3 $\mu$s (beispielsweise für Datenträger nach ISO/IEC 14443).

Weiterhin erfolgt bevorzugt das Anregen des Schaltkreises mittels des Energiepulses im Rahmen der vorstehend beschriebenen Alternative, d.h. bei kurzzeitig abgeschaltetem Wechselfeld, erst dann, wenn die aus dem vormals vorliegenden, angeschalteten Wechselfeld resultierende sinusförmige Schwingung bereits abgeklungen ist. Nur dann ergibt sich der vorstehend beschriebene Vorteil des einfacheren Auswertens der erfassten Schwingung in vollem Umfang. In diesem Fall entspricht die erfasste Schwingung des Schaltkreises genau der freien, gedämpften Schwingung des Schaltkreises, welche aus der Anregung des Schaltkreises durch den Energiepuls resultiert.

Wie erwähnt, wird im Schritt des Auswertens der wie vorstehend beschrieben erfassten oder ermittelten freien, gedämpften Schwingung des Schaltkreises insbesondere die Eigenresonanzfrequenz des Schaltkreises und die Güte des Schaltkreises in Abhängigkeit von der Feldstärke des vorliegenden magnetischen Wechselfeldes ermittelt. Daraus können, wie beschrieben, in vielfältiger Weise Rückschlüsse auf die Funktionsfähigkeit des Schaltkreises gezogen werden.

Es versteht sich, dass das Verfahren, wie ebenfalls bereits erwähnt, in jeder der beschriebenen Varianten mit jeweils veränderter Feldstärke des magnetischen Wechselfeldes wiederholt werden kann. Auf diese Weise kann insbesondere die Abhängigkeit der Messergebnisse von der Feldstärke überprüft werden. Beispielsweise lassen identische Messergebnisse bei verschiedenen Feldstärken auf einen defekten Schaltkreis schließen.

Gängige Feldstärken, bei denen das Verfahren wiederholt werden kann, sind insbesondere solche, die einer Betriebsfeldstärke eines kontaktlosen kommunizierenden Datenträgers der vorstehend genannten Varianten entspricht, d.h. Feldstärken im Bereich von 0 bis 12 A/m, besonders bevorzugt zwischen 1,5 und 7,5 A/m bzw. zwischen 0,15 und 7,5 A/m.

Eine erfindungsgemäße Messvorrichtung zum Prüfen eines zur kontaktlosen Datenkommunikation eingerichteten Schaltkreises umfasst dabei folgende Komponenten:

Eine Sendeeinrichtung mit einer Sendeantenne ist eingerichtet, ein magnetisches Wechselfeld einer vorgegebenen Frequenz und einer konstanten (vorgegebenen) Feldstärke zu erzeugen.

Ein Impulsgeber ist eingerichtet, einen in der Messvorrichtung anordenbaren, zu prüfenden Schaltkreis über eine an den Impulsgeber angeschlossene Erregerspule kontaktlos anzuregen.

Eine Messantenne ist eingerichtet, eine Schwingung eines angeordneten, zu prüfenden Schaltkreises zu erfassen.

Eine Auswertungseinrichtung schließlich, welche mit der Messantenne verbunden ist, ist eingerichtet, die von der Messantenne erfasste Schwingung des zu prüfenden Schaltkreises auszuwerten, insbesondere hinsichtlich einer Eigenresonanzfrequenz des Schaltkreises.

Die Auswertungseinrichtung kann dabei insbesondere einen Vergleich mit Referenzwerten einer intakten Antennenspule heranziehen. Zur Analyse der von der Messantenne beim Erfassen der Schwingung erfassten Signale kann in bekannter Weise beispielsweise ein digitaler Signalprozessor (DSP) oder ein Oszilloskop dienen.

Gemäß einer bevorzugten Ausführungsform kann die Messvorrichtung eine Kalibriereinrichtung mit einer Kalibrierantenne umfassen. Die Kalibriereinrichtung ist eingerichtet, Parameter des durch die Sendeinrichtung erzeugten magnetischen Wechselfeldes, insbesondere eine Feldstärke des Wechselfeldes in Bereich der Kalibrierantenne, zu erfassen. Alternativ kann eine Kalibrierung der Messvorrichtung auch bereits während der Herstellung der Messvorrichtung erfolgen. In diesem Fall ist die Kalibriereinrichtung während des Prüfens des Schaltkreises verzichtbar.

Vorzugsweise ist die Messvorrichtung derart eingerichtet, dass der zu prüfende Schaltkreis, welcher, wie erwähnt, eine Antenne und ein mit der Antenne gekoppeltes elektronisches Bauteil umfasst, in der Messvorrichtung derart angeordnet werden kann, dass die Antenne des Schaltkreises in einem Bereich angeordnet wird, in dem das Wechselfeldes eine vorgegebene Feldstärke aufweist. Dieser Bereich ist, wie erwähnt, vorzugsweise jeweils mittels der Kalibrierantenne in exakter Weise ermittelbar.

Konkret kann dies beispielsweise dadurch erfolgen, dass der zu prüfende Schaltkreis in der Messvorrichtung derart angeordnet wird, dass die Antenne des Schaltkreises und die Kalibrierantenne koaxial zu der Sendeantenne angeordnet sind. Weiter werden die Antenne des Schaltkreises und die Kalibrierantenne auf jeweils verschiedenen Seiten der Sendeantenne angeordnet. Schließlich ist der Abstand, in dem jede der beiden Antennen zu der Sendeantenne angeordnet wird, jeweils der gleiche. Eine vergleichbare Prüfanordnung ist beispielsweise aus der Norm ISO/IEC 10373-6 im Zusammenhang mit der Messung einer feldstärkenabhängigen Lastmodulationsamplitude bekannt.

Die Erregerspule und die Messantenne der Messvorrichtung sind vorzugsweise orthogonal zueinander angeordnet. In dem Fall, dass die Erregerspule und die Messantenne nicht orthogonal zueinander, sondern beispielsweise nebeneinander angeordnet sind, wird der Erregungspuls der Erregerspule auch von der Messantenne erfasst. Zudem überlagert dann das Abschwingverhalten der Erregerspule das zu messende Abschwingverhalten der Antennenspule.

Bei einer "orthogonalen" Anordnung der Erregerspule zu der Messantenne liegen diese derart zueinander, dass das Signal der Erregerspule von der Messantenne nicht wahrgenommen wird. Die Erregerspule ist dabei gegenüber der Messantenne räumlich so angeordnet, dass in der Messantenne im Wesentlichen kein Signal eingekoppelt wird. Ein Signal wird in eine Spule immer dann eingekoppelt, wenn das Ringintegral über den magnetischen Fluss $\Phi$ durch diese Spule größer als Null ist (vgl. oben zitiertes RFID-Handbuch, Kapitel 4.1.6 und 4.1.9.2). Das Integral über den magnetischen Fluss $\Phi$ ist genau dann Null, wenn sich magnetische Feldlinien unterschiedlicher Richtung und Feldstärke in der Messantenne über die Gesamtfläche gegenseitig aufheben, oder wenn der Winkel der Feldlinien zur Spulenachse genau 90° beträgt - daher der Begriff "orthogonale" Anordnung. Eine geeignete, so genannte koplanare orthogonale Anordnung der Erregerspule zur Messantenne kann beispielsweise derart erfolgen, dass die beiden Antennen in einer Ebene geeignet teilweise übereinander liegen.

Die Sendeeinrichtung der Messvorrichtung ist vorzugsweise eingerichtet, ein magnetisches Wechselfeld unterschiedlicher Feldstärken erzeugen. Wie bereits erwähnt, sollten darunter zumindest Feldstärken im Bereich der gängigen Betriebsfeldstärken kontaktlos kommunizierender Datenträger oder Geräte liegen, d.h. Feldstärken im Bereich von 0 bis 12 A/m, insbesondere im Bereich von 1,5 bis 7,5 A/m für ISO/IEC 14443 bzw. 0,15 bis 7,5 A/m für ISO/IEC 15693.

Das erzeugte Magnetfeld und der Schaltkreis sind vorzugsweise vorgesehen bzw. eingerichtet für eine Kommunikation im Nahbereich, also mittels induktiver Kopplung bzw. Lastmodulation. In besonders bevorzugten Ausgestaltungen erfolgt das Prüfen während einer laufenden Datenkommunikation mit dem Schaltkreis. Das erzeugte Wechselfeld wird zur Datenkommunikation mit dem Schaltkreis verwendet. Die Schritte des Anregens und Erfassens erfolgen dabei in einer Phase der Kommunikation, in welcher keine Modulation des Wechselfeldes erfolgt oder in einer Phase der Kommunikation, in welcher kurzzeitig kein Wechselfeld erzeugt wird.

Die Messantenne der Messvorrichtung sollte vorzugsweise derart ausgebildet sein, dass sie selbst durch ihre physikalischen Eigenschaften die Messung der Schwingung des zu prüfenden Schaltkreises nicht oder nur unwesentlich beeinflusst. Dazu sollte die Messantenne möglichst breitbandig ausgelegt sein und lediglich eine sehr gering ausgeprägte Spannungsüberhöhung im Bereich ihrer Resonanzfrequenz aufweisen. Insbesondere sollte ein Ausschwingen der Messantenne in Reaktion auf die Anregung mittels der Erregerspule, welches grundsätzlich auch von der Messantenne wahrgenommen werden kann, im Wesentlichen unterdrückt werden.

Um dies zu erreichen, umfasst die Messantenne gemäß einer bevorzugten Ausführungsform eine Leiterschleife und eine Mehrzahl ohmscher Widerstände, wobei Widerstände in vorgegebenen Abständen in die Leiterschleife eingefügt sind. Mit anderen Worten, durch das Einfügen der Widerstände in die Leiterschleife entsteht eine Mehrzahl von Leitungssegmenten der Leiterschleife, welche durch die ohmschen Widerstände verbunden werden. Leitungssegmente und Widerstände sind dabei jeweils abwechselnd und in Reihe geschaltet.

Auf diese Weise entsteht eine Leiterschleife mit dazu in Reihe geschaltetem hochohmigem Widerstand. Dies könnte zwar grundsätzlich auch dadurch erreicht werden, dass ein einzelner hochohmiger Widerstand in Reihe mit der Leiterschleife geschaltet wird. Da in der Praxis aber auch parasitäre Kapazitäten in Betracht gezogen werden müssen, die sich entlang der Leiterschleifen bilden, hat der beschriebene Aufbau der bevorzugten Messantenne verschiedene Vorteile. Dadurch, dass der Widerstand nicht als einzelner Widerstand vorliegt, sondern als Mehrzahl entlang der Leiterschleife geschalteter "Teilwiderstände", werden die auftretenden parasitären Kapazitäten nicht mehr als Gesamtkapazität wirksam. Mit anderen Worten, während ein einzelner Widerstand, der in Reihe zu der Leiterschleife geschaltet werden würde, aufgrund einer entlang der Leiterschleife auftretenden parasitären Kapazität, welche dann als Gesamtkapazität in Erscheinung treten würde, zusammen mit der Induktivität der Leiterschleife einen Schwingkreis mit ungünstigerweise hoher Güte - wegen des hochohmigen Scheinwiderstandes - bilden würde, erlaubt der beschriebene, bevorzugte Aufbau eine wirksame Dämpfung der Messantenne.

Gegenüber einer Ausführungsform, bei der der Widerstand dadurch entlang der Leiterschleife "gleichmäßig" verteilt wird, dass die Leiterschleife der Messantenne aus einem hochohmigen Material, wie beispielsweise Graphit, hergestellt wird, hat der beschriebene Aufbau den Vorteil einer einfachen und insbesondere kostengünstigeren Herstellung.

Die Abstände zwischen je zwei entlang der Leiterschleife benachbart eingefügten Widerständen sind dabei vorzugsweise regelmäßig. Die Anzahl, der Abstand und die Dimension der Widerstände sind grundsätzlich variabel. Vorzugsweise werden zumindest fünf Widerstände entlang der Leiterschleife angeordnet, vorzugsweise 8 bis 10 Widerstände, die Anzahl kann aber auch größer sein. In der Regel sind die Widerstände gleich dimensioniert, Abweichungen zwischen einzelnen Widerstandswerten sind möglich.

Vorzugsweise ist an die Messantenne unmittelbar ein Verstärker angeordnet. Dadurch kann eine lange, kapazitätsbelegte Zuleitung vermieden werden. Der Verstärker umfasst bevorzugt einen hochohmigen Eingang. Als Verstärker kann beispielsweise ein Impedanzwandler verwendet werden. Dessen Ausgangsimpedanz ist dann vorzugsweise an ein Übertragungsmittel angepasst, welches den Impedanzwandler mit der Auswertungseinrichtung verbindet. Als Verbindungsmittel wird vorzugsweise ein Koaxialkabel verwendet. In diesem Fall beträgt die Ausgangsimpedanz des Impedanzwandlers 50 Ω.

Die Auswertungseinrichtung, welche beispielsweise ein Oszilloskop sein kann, weist bevorzugt eine Eingangsimpedanz auf, welche in gleicher Weise an ein Übertragungsmittel angepasst ist, welches die Auswertungseinrichtung mit der Messantenne verbindet, beispielsweise das genannte Koaxialkabel.

Die vorliegende Erfindung wird nachfolgend mit Bezug auf die beiliegenden Zeichnungen beispielhaft beschrieben. Darin zeigen:

Figur 1            eine bevorzugte Ausführungsform einer erfindungsgemäßen Messvorrichtung;

Figur 2A           eine bevorzugte Ausführungsform einer Messantenne der Messvorrichtung aus Fig. 1;

Figur 2B           eine Ersatzschaltung der Messantenne aus Figur 2A;

Figur 2C           eine Anordnung der Messantenne aus Figur 2A relativ zu einer Erregerspule der Messvorrichtung aus Fig. 1;

Figur 3      Schritte einer bevorzugten Ausführungsform eines erfindungsgemäßen Verfahrens zum Prüfen eines zur kontaktlosen Datenkommunikation eingerichteten Schaltkreises;

Figur 4      den Verlauf einer freien, gedämpften Schwingung;

Figur 5      exemplarisch den Verlauf einer Schwingung, wie sie in Schritt S4 aus Figur 3 erfasst werden kann;

Figur 6      exemplarisch Teilschritte des Auswertens der erfassten Schwingung aus Figur 5;

Figuren 7A und 7B      exemplarisch das Ermitteln einer Betriebsresonanzfrequenz eines zu prüfenden Schaltkreises;

Figur 8A      ein erfasstes Signal gemäß einer Variante des Verfahrens nach Figur 3; und

Figur 8B      die Schritte eines Verfahrens gemäß dieser Variante.

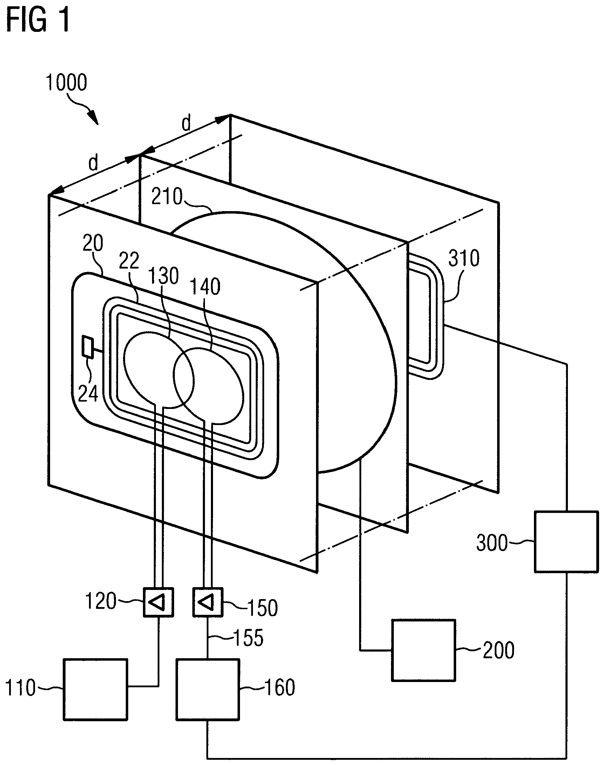

Die in Figur 1 exemplarisch dargestellte Messevorrichtung 1000 dient zum Prüfen eines zur kontaktlosen Datenkommunikation eingerichteten Schaltkreises 20, welcher im vorliegenden Beispiel in Form einer kontaktlos kommunizierenden Chipkarte dargestellt ist. Diese umfasst eine Antennenspule 22, welche mit einem elektronischen Bauteils 24 zu einem zu prüfenden Schaltkreis 20 verbunden ist.

Die Antenne 22 des Schaltkreises 20, wenn der Schaltkreis zur Prüfung in der Messvorrichtung angeordnet ist, ist zu einer Sendeantenne 210 einer Sendeeinrichtung 200 der Messvorrichtung 1000 koaxial angeordnet.

Ebenfalls koaxial zu der Sendeantenne 210 ist eine Kalibrierantenne 310 einer Kalibriereinrichtung 300 angeordnet. Die Kalibriereinrichtung 300 mit der Kalibrierantenne 310 kann Teil der Messvorrichtung 1000 sein. Die Kalibrierantenne 310 sowie die Antenne 22 des zu prüfenden Schaltkreises 20 sind, wie illustriert, zu jeweils verschiedenen Seiten der Sendeantenne 210 und in jeweils gleichem Abstand d zu der Sendeantenne 210 angeordnet.

Mittels der Sendeeinrichtung 200 und der Sendeantenne 210 kann ein magnetisches Wechselfeld einer einstellbaren Feldstärke H und mit einer vorgegebenen Frequenz erzeugt werden. Insbesondere ist die Sendeeinrichtung 200 eingerichtet, ein magnetisches Wechselfeld mit einer für den Betrieb eines zu prüfenden Datenträgers 20 üblichen Betriebsfeldstärke H zu erzeugen. Im Zusammenhang mit Datenträgern gemäß ISO/EC 14443 sind übliche Betriebsfeldstärken beispielsweise 1,5 bis 7,5 A/m. Bevorzugt umfasst der Bereich, den die Sendeeinrichtung 200 abdeckt, ein größeres Intervall, beispielsweise 0 bis 12 A/m, bevorzugt auch noch höhere Feldstärken.

Die Kalibriereinrichtung 300 mit der Kalibrierantenne 310 dient dazu, die Feldstärke H des mittels der Sendeeinrichtung 200 erzeugten Wechselfeldes in einem definierten Abstand d von der Sendeantenne 210 genau zu erfassen. Aufgrund der Tatsache, dass die Antenne 22 eines zu prüfenden Datenträgers 20 in der Messvorrichtung 1000 relativ zu der Sendeantenne 210 in gleicher räumlicher Anordnung, koaxial, und gleichem Abstand d wie die Kalibrierantenne 310 angeordnet werden kann, kann davon ausgegangen werden, dass im Bereich der Antenne 22 des zu prüfenden Schaltkreises 20 genau die gleiche Feldstärke H vorliegt, wie im Bereich der Kalibrierantenne 310.

Die Messvorrichtung 1000 umfasst weiterhin einen Impulsgeber 110, der vorzugsweise über einen Verstärker 120 mit einer Erregerspule 130 verbunden ist. Mittels eines durch den Impulsgeber 110 erzeugten Energiepulses, vorzugsweise in Form eines Dirac-Stoßes, kann der zu prüfende Schaltkreis 20 über die Erregerspule kontaktlosen angeregt werden.

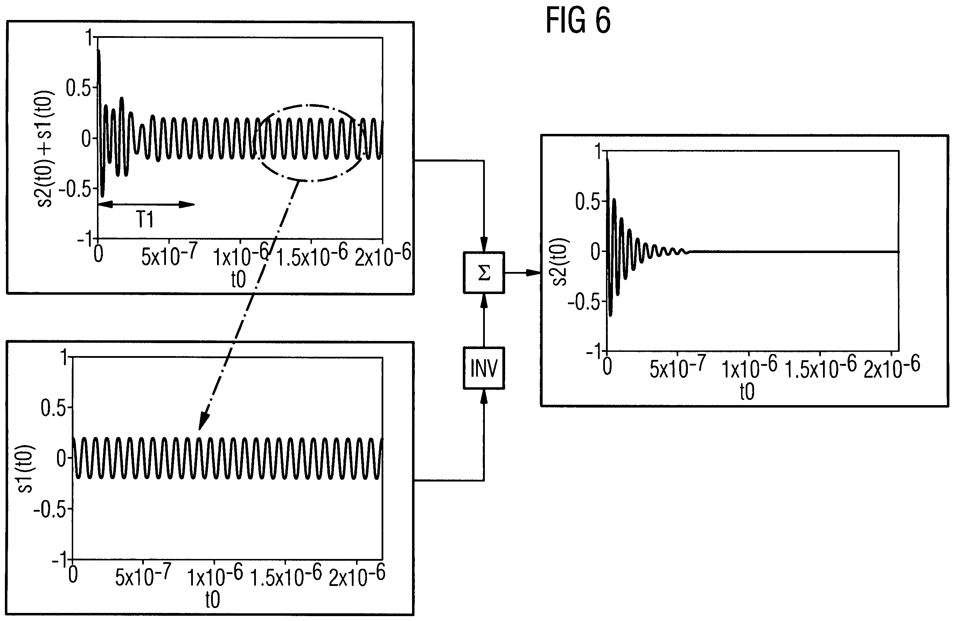

Eine Messantenne 140 der Messvorrichtung 1000 ist eingerichtet, eine Schwingung des zu prüfenden Schaltkreises 20 zu erfassen und vorzugsweise über einen Verstärker 150 an eine Auswertungseinrichtung 160 weiterzuleiten. Die Auswertungseinrichtung 160 kann beispielsweise als Oszilloskop vorliegen und ist vorzugsweise, wie nachfolgend mit Bezug auf Figur 6 beschrieben, mit der Kalibriereinrichtung 300 verbunden.

Erregerspule 130 und Messantenne 140 werden in geeignetem, vorzugsweise geringem Abstand neben der Antenne 22 des zu prüfenden Schaltkreises 20 angeordnet, auf der der Sendeantenne zugewandten oder, wie in Fig. 1 illustriert, auf der der Sendeantenne 210 abgewandten Seite des Datenträgers 20.

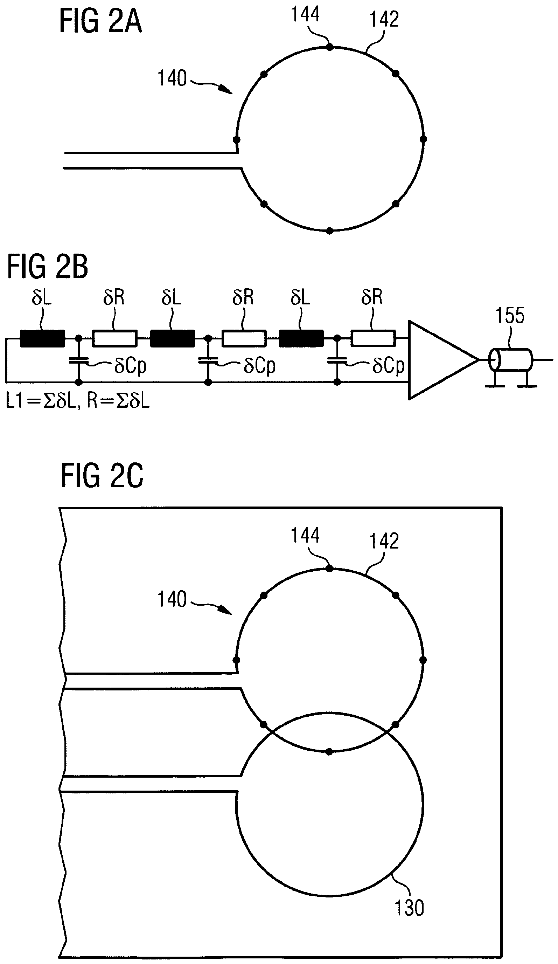

Figur 2A zeigt eine bevorzugte Ausführungsform der Messantenne 140 aus Fig. 1. Die Messantenne 140 umfasst eine Leiterschleife und eine Mehrzahl ohmscher Widerstände 144, wobei die Widerstände 144 in vorgegebenen Abständen in die Leiterschleife eingefügt sind. Dabei ergeben sich Leitungssegmente 142, welche, wie illustriert, mit den Widerständen 144 in Reihe geschaltet sind. Die Abstände zwischen benachbarten Widerständen 144 entlang der Leiterschleife sind vorzugsweise jeweils gleich. Die Anzahl der Widerstände 144 bzw. der Leitungssegmente 142 ist variabel. In der Regel sind sämtliche der Widerstände 144 gleich dimensioniert. Als Widerstände 144 können beispielsweise direkt auf die Leiterbahnen lötbare SMD-Widerstände verwendet werden.

Figur 2B zeigt ein Ersatzschaltbild der Messantenne 140 aus Figur 2A. Darin entsprechen die symbolisch gezeigten Widerstände δR den ohmschen Widerständen 144, die Elemente δL addieren sich zu der Induktivität L1 der Leiterschleife und die sich entlang der Leiterschleife bildenden parasitären Kapazitäten sind mit δCp bezeichnet. Dadurch, dass die Widerstände 144 im Wesentlichen gleichmäßig entlang der Leiterschleife verteilt angeordnet sind, werden die parasitären Kapazitäten δCp nicht als Gesamtkapazität Cp wirksam, wodurch die Messantenne 140 wirkungsvoll "gedämpft" werden kann.

Um eine günstige Signalauskopplung zu erreichen, sollte das mittels der Messantenne 140 erfasste Signal möglichst hochohmig ausgekoppelt werden. Daher wird unmittelbar an die Messantenne 140, wie in Figur 1 dargestellt, ein Verstärker 150 mit hochohmigem Eingang angeordnet. Vorzugsweise wird als Verstärker 150 ein Impedanzwandler eingesetzt. Dieser besitzt vorzugsweise eine Ausgangsimpedanz von 50Ω und ist mittels eines Koaxialkabels 155 mit der Auswertungseinrichtung 160 verbunden, beispielsweise einem Oszilloskop. Dieses sollte dabei vorzugsweise eine Eingangsimpedanz von 50 Ω aufweisen. Damit können Reflexionen wirkungsvoll vermieden werden.

Ein weiterer Vorteil der Messantenne 140 aus Figur 2A besteht darin, dass bedingt durch den hohen Widerstand der Leiterschleife und einem entsprechend hohen Eingangswiderstand des Impedanzwandlers der Strom in der Messantenne gegen Null geht. Mit anderen Worten, an den Anschlüssen der Messantenne 140 wird praktisch nur Spannung gemessen. Wird der Strom in der Messantenne 140 sehr klein, so wird dadurch auch eine Rückwirkung auf die Antenne 22 des zu prüfenden Schaltkreises 20 minimiert. Dadurch wird das Messergebnis durch die Messantenne 140 praktisch nicht beeinflusst.

Figur 2C zeigt eine bevorzugte Ausführungsform einer Anordnung der Messantenne 140 relativ zu der Erregerspule 130. Messantenne 140 und Erregerspule 130 sind dabei orthogonal zueinander angeordnet. Dies hat, wie vorstehend beschrieben, die Auswirkungen, dass in die Messantenne 140 möglichst kein Signal der Erregerspule 130 eingekoppelt wird. Die Erregerspule 130 und die Messantenne können auf einem geeigneten, flächigen Träger angeordnet werden.

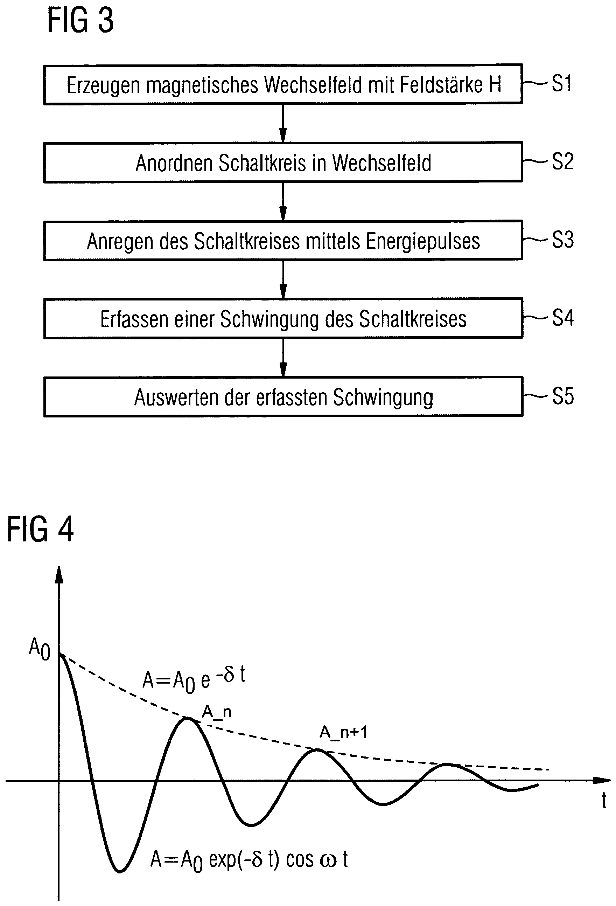

In Figur 3 sind wesentliche Schritte einer bevorzugten Ausführungsform eines Verfahrens zum Prüfen eines zur kontaktlosen Datenkommunikation eingerichteten Schaltkreises 20 angegeben.

In einem ersten Schritt S1 wird ein magnetisches Wechselfeld mit einer vorgegebenen, definierten Feldstärke H erzeugt. Dies kann mittels der mit Bezug auf Figur 1 erläuterten Sendeeinrichtung 200 erfolgen.

Im Schritt S2 wird der Schaltkreis 20 in dem Bereich des Wechselfeldes angeordnet. In der Regel wird der Schaltkreis 20 in dem erzeugten Wechselfeld angeordnet. Die Anordnung erfolgt derart, dass die Feldstärke H im Bereich der Antenne 22 des zu prüfenden Schaltkreises 20 genau einstellbar ist, wie dies ebenfalls mit Bezug auf Figur 1 beschrieben worden ist. Der Schaltkreis 20 kann aber auch bereits vor dem Schritt S1 des Erzeugens in dem Bereich des zu erzeugenden Wechselfeldes angeordnet werden. Diese Reihenfolge der Schritte ist beispielsweise sinnvoll, wenn die genaue Feldstärke bereits vorab eingestellt wurde (z.b. bei Prüfung des x-ten gleichartigen Datenträgers) oder die Einhaltung der genauen Feldstärke für die Prüfung nicht erforderlich ist (z.b. bei Prüfung gleichartiger Datenträger auf Konformität oder auf einen Referenzwert unter Verwendung der vorkonfigurierten Prüfvorrichtung).

Im Schritt S3 wird der Schaltkreis 20 mittels eines Energiepulses angeregt. Dies kann mittels der Erregerspule 130 aus Figur 1 durch Zusammenwirken mit dem Impulsgeber 110 erfolgen. Das Anregen erfolgt vorzugsweise mittels eines gepulsten Magnetfeldes induktiv, wobei das Magnetfeld vorzugsweise durch einen einzelnen Strompuls in Form eines Dirac-Stoßes erzeugt wird.

Im Schritt S4 wird eine Schwingung des Schaltkreises 20 in Antwort auf das Anregen des Schaltkreises 20 erfasst. Dazu dient die Messantenne 140 aus Figur 1 bzw. Fig. 2A.

Im Schritt S5 wird die erfasste Schwingung durch eine Auswertungseinrichtung, beispielsweise die Auswertungseinrichtung 160 aus Fig. 1, ausgewertet.

Der Schritt des Auswertens S5 umfasst das Bestimmen des Prüfungsergebnisses. Die erfasste Schwingung und/oder daraus bestimmte Werte können mit Vorgaben (vorbestimmten Referenzen) abgeglichen werden. Insbesondere kann also ein Wert mit einem Referenzwert verglichen werden. Vorgegebene Toleranzen werden in dem Schritt S5 berücksichtigt. Insbesondere werden im Schritt des Auswertens S5 Eigenschaften des Schaltkreises, wie Güte und/oder Eigenresonanzfrequenz, bestimmt.

Das Anordnen des Schaltkreises 20 im Wechselfeld gemäß Schritt S2 versetzt den Schaltkreis 20 aufgrund der Sendefrequenz der Sendeantenne 210 in eine bezüglich Amplitude und Frequenz konstante sinusförmige Schwingung.

Das Anregen des Schaltkreises 20 mittels des Energiepulses gemäß Schritt S3 resultiert in einer freien, gedämpften Schwingung des Schaltkreises 20, wie sie exemplarisch in Figur 4 dargestellt ist.

Es sei an dieser Stelle angemerkt, dass im Zusammenhang mit der vorliegenden Erfindung der Begriff des "Anregens" des Schaltkreises ausschließlich im Zusammenhang mit dem Anregen des Schaltkreises mittels des Energiepulses (Schritt S3) verwendet werden soll. Der Einfluss des magnetischen Wechselfeldes, welcher ebenfalls eine Wirkung auf das Schwingungsverhalten des Schaltkreises hat, wird vorliegend nicht als "Anregen" des Schaltkreises im Sinne der Erfindung verstanden.

Figur 4 zeigt den theoretischen Verlauf einer freien, gedämpften Schwingung A(t) im Verlauf der Zeit t. Die Funktion A(t) kann dabei dem Strom I oder der Spannung U entsprechen. Die Kreisfrequenz $\omega$ entspricht der Eigenresonanzfrequenz des entsprechenden Schaltkreises 20 multipliziert mit 2 $\pi$. Aus dem Abklingkoeffizienten $\delta$ kann die Güte des Schaltkreises 20 bestimmt werden.

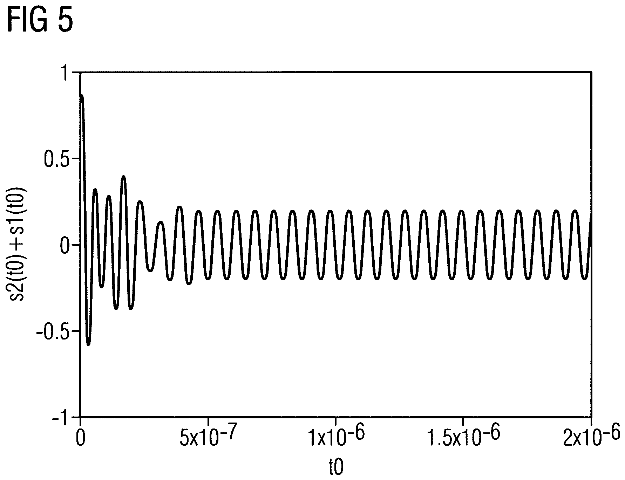

Figur 5 zeigt eine Überlagerung der erwähnten, konstanten sinusförmigen Schwingung mit einer freien, gedämpften Schwingung des Schaltkreises 20. Ein solches Signal kann von der Messantenne 140 im Schritt S4 erfasst werden. Um aus einer Schwingung, wie sie in Figur 5 dargestellt ist, eine Resonanzfrequenz des zu prüfenden Schaltkreises 20 zu ermitteln, muss derjenige Anteil der Schwingung, der der konstanten sinusförmigen Schwingung entspricht, welche durch das magnetische Wechselfeld erzeugt wird, von der erfassten Schwingung subtrahiert werden. Eine mögliche Vorgehensweise, eine solche Auswertung durchzuführen, ist in Figur 6 illustriert.

Der Verlauf der freien, gedämpften Schwingung kann beispielsweise mittels der Kalibrierantenne 310 erfasst und von der Auswertungseinrichtung 160 analysiert und gespeichert werden. Dazu ist die Kalibriereinrichtung 300 mit der Auswertungseinrichtung 160 verbunden. Der Schritt des Analysierens kann vor dem Anregen des Schaltkreises 20 mittels des Energiepulses erfolgen, oder, wie in Figur 6 illustriert, in ausreichendem zeitlichen Abstand nach dem Anregen des Schaltkreises 20 durch den Energiepuls, nämlich dann, wenn die freie, gedämpfte Schwingung bereits abgeklungen ist. Eine entsprechende Zeitspanne ist in Figur 6 mit T1 bezeichnet. Um die sinusförmige Schwingung von dem erfassten Gesamtsignal zu subtrahieren, wird diese invertiert und zu der erfassten Schwingung addiert, wie dies in Figur 6 exemplarisch dargestellt ist. In der rechten Teilfigur ist das Ergebnis, nämlich die freie, gedämpfte Schwingung des Schaltkreises 20, wie sie aus der Anregung des Schaltkreises 20 durch den Energiepuls resultiert, dargestellt.

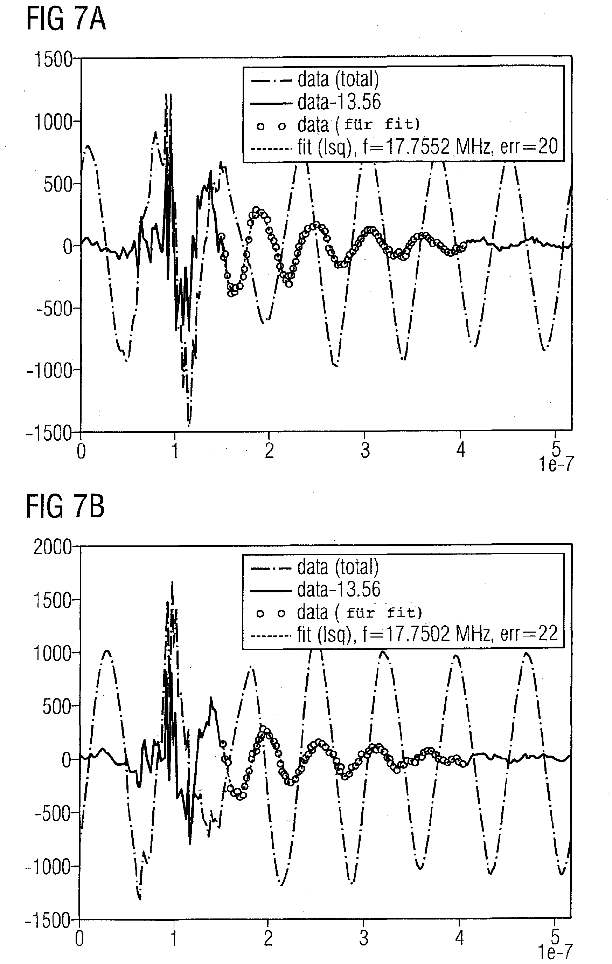

Ein Beispiel für eine Messung einer Betriebsresonanzfrequenz eines zu prüfenden Schaltkreises ist in Figur 7A dargestellt. Hierbei ist das erfasste Gesamtsignal, d.h. die sinusförmige Schwingung überlagert mit der freien, gedämpften Schwingung, strich-punktiert dargestellt. Nach dem Erfassen dieses Signals wurde der sinusförmige Anteil, der dem konstanten Wechselfeldes entspricht, subtrahiert. Das daraus resultierende Signal ist mit einer durchgezogenen Linie dargestellt und zeigt in anschaulicher Weise das Abklingen der freien, gedämpften Schwingung nach einem Dirac-Stoß. Schließlich zeigt Figur 7A noch das Ergebnis nach Anwendung eines Fit-Algorithmus, mit einer gestrichelten Linie, wobei verwendete Datenpunkte sichtbar gemacht sind.

Eine zweite Messung der Resonanzfrequenz desselben Schaltkreises 20, jedoch bei unterschiedlicher zweiter konstanter Feldstärke H', ist in Figur 7B dargestellt. Es zeigt sich, dass die Resonanzfrequenz des Schaltkreises 20 gegenüber der ersten Messung, mit der ersten Feldstärke H, sich um ca. 200 kHz unterscheidet. Dies ist auf die Feldstärkenabhängigkeit der Resonanzfrequenz des Schaltkreises 20 zurückzuführen.

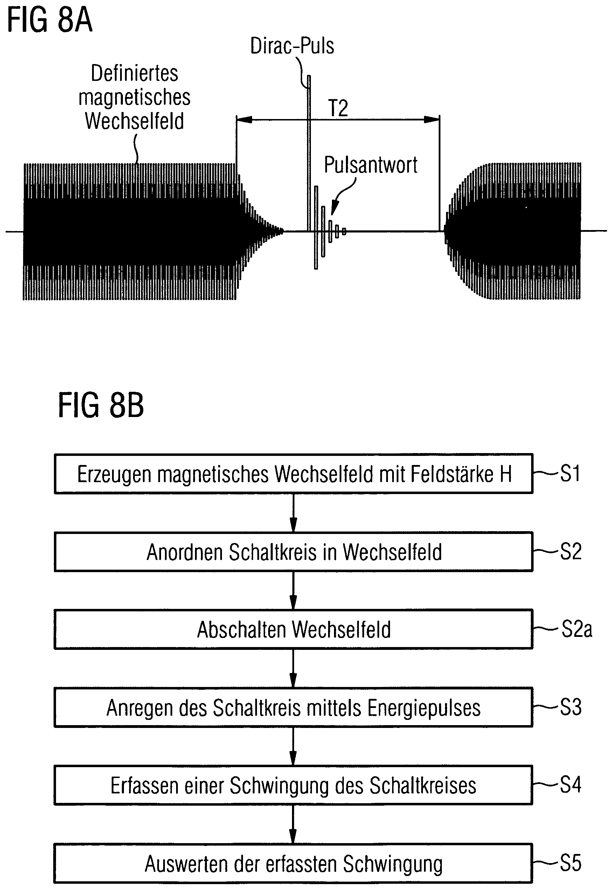

Mit Bezug auf Figur 8A ist der Signalverlauf eines von der Messantenne 140 erfassten Signals gemäß einem alternativen Prüfverfahren dargestellt. Wie mit Bezug auf Fig. 8B illustriert, gleichen sich das hier vorgestellte, alternative Verfahren und das vorstehend mit Bezug auf die Figuren 3 und 5 bis 7 beschriebene Verfahren in den Schritten S1 bis S5.

Das hier zugrunde liegende, alternative Prüfverfahren weicht von dem vorstehend beschriebenen Prüfverfahren dahingehend ab, dass das magnetische Wechselfeld zumindest kurzzeitig abgeschaltet wird (vgl. Schritt S2a in Fig. 8B).

Während im Rahmen des mit Bezug auf die Figuren 5 bis 7 beschriebenen Verfahrens das Anregen des Schaltkreises 20 (Schritt S3 in Figur 3) erfolgte, während das magnetische Wechselfeld angeschaltet war, d.h. mit konstanter Feldstärke H vorlag, erfolgt das Anregen gemäß der mit Bezug auf die Figuren 8A und 8B dargestellten Variante bei abgeschaltetem magnetischen Feld.

Wie in Figur 8A illustriert, wird das magnetische Wechselfeld vorzugsweise nur kurzzeitig abgeschaltet, beispielsweise für eine Zeitdauer T2, welche zum Beispiel ca. 3 $\mu$s betragen kann. In dieser Pause erfolgt das Anregen des Schaltkreises 20 mittels des Energiepulses, beispielsweise eines Direkt-Pulses. Dadurch, dass der Puls sehr kurz nach dem Ausschalten des magnetischen Wechselfeldes erfolgt, ist der Schaltkreis 20 weiterhin ausreichend mit Energie versorgt, so dass Schaltungs- und Betriebszustände verschiedener Elemente des Schaltkreises 20 im Wesentlichen den gleichen Zustand aufweisen, wie bei konstant vorliegendem Wechselfeld. Das Messergebnis, d.h. die ermittelte Resonanzfrequenz des Schaltkreises 20, wird sich im Vergleich zu einer Messung mit dauerhaft angeschaltetem Wechselfeld daher praktisch nicht oder allenfalls unwesentlich unterscheiden.

Für die Wirkungsweise des alternativen Verfahrens aus Fig. 8B ist es nicht wesentlich, wann und ob das magnetische Wechselfeld wieder angeschaltet wird. Grundsätzlich kann ein erneutes Anschalten unterbleiben. In der Regel aber wird die Abschaltung nur sehr kurzfristig sein, wie vorstehend beschrieben. Dies erlaubt beispielsweise auf einfache Weise eine mehrfache Wiederholung der Prüfung.

Vorzugsweise erfolgt das Anregen des Schaltkreises innerhalb der Zeitspanne, in der das Wechselfeld abgeschaltet ist, erst dann, wenn die sinusförmige Schwingung, welche durch das Wechselfeld hervorgerufen worden ist, abgeklungen ist, wie dies in Figur 8A dargestellt ist.

Diese Variante des Prüfverfahrens hat den Vorteil, dass das Auswerten der erfassten Schwingung in Antwort auf das Anregen des Schaltkreises 20 durch den Energiepuls vereinfacht wird. Wie in Figur 8A dargestellt, entspricht die in Schritt S4 aus Figur 8B erfasste Schwingung gemäß der vorliegenden Variante bereits nur die freie, gedämpfte Schwingung des Schaltkreises 20. Demzufolge kann auf eine Subtraktion weiterer, erfasster Schwingungsanteile verzichtet werden.

**Patentansprüche**

1. Verfahren zum Prüfen eines zur kontaktlosen Datenkommunikation eingerichteten Schaltkreises (20), welcher eine Antenne (22) und ein mit der Antenne (22) gekoppeltes elektronisches Bauteil (24) umfasst, umfassend die Schritte:

   - Erzeugen (S1) eines magnetischen Wechselfeldes für den Schaltkreis (20);
   - Anregen (S3) des Schaltkreises (20) mittels eines Energiepulses,
   - Erfassen (S4) einer Schwingung des Schaltkreises (20) in Antwort auf die Anregung durch den Energiepuls; und
   - Auswerten (S5) der erfassten Schwingung des Schaltkreises (20); wobei während des Anregens (S3) das Erzeugen (S1) des magnetischen Wechselfelds erfolgt, und

   wobei das Anregen des Schaltkreises (20) durch den Energiepuls bei konstant vorliegendem magnetischem Wechselfeld erfolgt.

2. Verfahren nach Anspruch 1, **gekennzeichnet durch**,

   - Anordnen (S2) des Schaltkreises (20) in dem Bereich des Wechselfelds.

3. Verfahren nach Anspruch 1 oder 2, **dadurch gekennzeichnet, dass** das Anregen (S3) des Schaltkreises als induktives Anregen mittels eines gepulsten Magnetfeldes erfolgt, wobei das Magnetfeld vorzugsweise durch einen einzelnen Strompuls erzeugt wird.

4. Verfahren nach Anspruch 3, **dadurch gekennzeichnet, dass** der Strompuls als Gleichstrompuls in Form eines Dirac-Stoßes erzeugt wird.

5. Verfahren nach einem der vorhergehenden Ansprüche, **dadurch gekennzeichnet, dass** das Anregen des Schaltkreises (20) kontaktlos mittels einer externen Erregerspule (130) durchgeführt wird und/oder dass das Erfassen der Schwingung des Schaltkreises (20) kontaktlos mittels einer externen Messspule (140) durchgeführt wird.

6. Verfahren nach einem der vorhergehenden Ansprüche, **dadurch gekennzeichnet, dass** das Wechselfeld mittels einer Sendeantenne (210) erzeugt wird und dass die Feldstärke (H) des Wechselfeldes mittels einer Kalibrierantenne (310) gemessen wird, um ein Erzeugen des Wechselfeldes gemäß einer vorgegebenen Feldstärke (H) zu ermöglichen, wobei die Kalibrierantenne (310) und die Antenne (22) des Schaltkreises (20) vorzugsweise derart relativ zu der Sendeantenne (210) angeordnet werden, dass im Bereich der Kalibrierantenne (310) und im Bereich der Antenne (22) des Schaltkreises (20) jeweils ein magnetisches Wechselfeld der gleichen Feldstärke (H) vorliegt.

7. Verfahren nach einem der Ansprüche 1 bis 6, **dadurch gekennzeichnet, dass** das Erfassen der Schwingung des Schaltkreises ein Erfassen einer Überlagerung einer durch das Wechselfeld hervorgerufenen sinusförmigen Schwingung des Schaltkreises (20) mit einer freien, gedämpften Schwingung des Schaltkreises (20) umfasst, wobei die freie, gedämpfte Schwingung aus der Anregung durch den Energiepuls resultiert.

8. Verfahren nach Anspruch 7, **dadurch gekennzeichnet, dass** das Auswerten der erfassten Schwingung des Schaltkreises (20) eine Subtraktion der konstanten sinusförmigen Schwingung von der erfassten Schwingung umfasst, um die freie, gedämpfte Schwingung zu ermitteln.

9. Verfahren nach Anspruch 8, **dadurch gekennzeichnet, dass** die Subtraktion der konstanten sinusförmigen Schwingung von der erfassten Schwingung mittels Software oder mittels Hardware, insbesondere unter Verwendung eines Verstärkers und/oder vorzugsweise durch Addition eines Signals, welches dem von der Kalibrierantenne (310) erfassten und invertierten Signal entspricht, durchgeführt wird.

10. Verfahren nach Anspruch 8, **dadurch gekennzeichnet, dass** im Schritt des Auswertens aus der erfassten oder ermittelten freien, gedämpften Schwingung des Schaltkreises (20) die Eigenresonanzfrequenz und/oder die Güte des Schaltkreises (20) für die Feldstärke (H) des magnetischen Wechselfeldes ermittelt wird.

11. Verfahren nach einem der vorhergehenden Ansprüche, **dadurch gekennzeichnet, dass** das Verfahren mit veränderter Feldstärke (H) des magnetischen Wechselfeldes wiederholt wird, das Auswerten der erfassten Schwingung in Abhängigkeit von der Feldstärke (H) des magnetischen Wechselfeldes erfolgt, in welchem der Schaltkreis (20) angeordnet ist.

**12.** Verfahren nach einem der vorhergehenden Ansprüche, **dadurch gekennzeichnet, dass** das Auswerten der erfassten Schwingung in Abhängigkeit eines durch das Vorliegen des magnetischen Wechselfeldes bedingten Betriebs- oder Schaltungszustandes eines oder mehrerer Komponenten des elektronischen Bauteils (24) erfolgt.

**13.** Vorrichtung (1000) zum Prüfen eines zur kontaktlosen Datenkommunikation eingerichteten Schaltkreises (20), welcher eine Antenne (22) und ein mit der Antenne (22) gekoppeltes elektronisches Bauteil (24) umfasst, mit:

- einer Sendeeinrichtung (200) mit einer Sendeantenne (210), die eingerichtet ist ein magnetisches Wechselfeld für einen in der Messvorrichtung (1000) anordenbaren, zu prüfenden Schaltkreis (20) zu erzeugen,
- einem Impulsmittel (110, 130), das eingerichtet ist den zu prüfenden Schaltkreis (20) zusätzlich anzuregen, und
- einem Auswertungsmittel (140, 160) das eingerichtet ist, eine in Antwort auf die Anregung durch das Impulsmittel (110,130) erfasste Schwingung des zu prüfenden Schaltkreises (20) auszuwerten,

wobei die Vorrichtung (1000) eingerichtet ist, das magnetische Wechselfeld aufrecht zu erhalten, während der Schaltkreis (20) zusätzlich angeregt wird.

**14.** Vorrichtung nach Anspruch 13 **dadurch gekennzeichnet, dass** das Auswertungsmittel (160), welches mit der Messantenne (140) verbunden ist, eingerichtet ist, aus der von der Messantenne (140) erfassten Schwingung des Schaltkreises (20) eine von der Feldstärke abhängige Eigenschaft des Schaltkreises (20) für die erzeugte Feldstärke zu bestimmen.

**15.** Vorrichtung nach Anspruch 13 oder 14 **dadurch gekennzeichnet, dass** die Vor-richtung zur Durchführung eines Verfahrens nach einem der Ansprüche 2 bis 12 eingerichtet ist.

**Claims**

**1.** A method for checking a circuit (20) devised for contactless data communication, which comprises an antenna (22) and an electronic component (24) coupled with the antenna (22), comprising the steps of:

- generating (S1) an alternating magnetic field for the circuit (20);
- exciting (S3) the circuit (20) by means of an energy pulse,
- capturing (S4) an oscillation of the circuit (20) in response to the excitation by the energy pulse; and
- evaluating (S5) the captured oscillation of the circuit (20);

wherein during the exciting (S3) the generating (S1) of the alternating magnetic field is effected, and
wherein the exciting of the circuit (20) by the energy pulse is effected with the alternating magnetic field constantly present.

**2.** The method according to claim 1, **characterized by**

- arranging (S2) the circuit (20) in the region of the alternating field.

**3.** The method according to claim 1 or 2, **characterized in that** the exciting (S3) of the circuit is effected as inductive exciting by means of a pulsed magnetic field, with the magnetic field preferably being generated by a single current pulse.

**4.** The method according to claim 3, **characterized in that** the current pulse is generated as a direct-current pulse in the form of a Dirac impulse.

**5.** The method according to any of the preceding claims, **characterized in that** the exciting of the circuit (20) is carried out contactlessly by means of an external exciting coil (130), and/or that the capturing of the oscillation of the circuit (20) is carried out contactlessly by means of an external measuring coil (140).

**6.** The method according to any of the preceding claims, **characterized in that** the alternating field is generated by means of a transmitting antenna (210), and that the field strength (H) of the alternating field is measured by means of a calibrating antenna (310) in order to enable a generating of the alternating field according to a pre-specified field strength (H), with the calibrating antenna (310) and the antenna (22) of the circuit (20) preferably being arranged relative to the transmitting antenna (210) such that an alternating magnetic field of the same field strength (H) is respectively present in the region of the calibrating antenna (310) and in the region of the antenna (22) of the circuit (20).

7.  The method according to any of claims 1 to 6, **characterized in that** the capturing of the oscillation of the circuit comprises a capturing of a superimposition of a sinusoidal oscillation of the circuit (20) brought about by the alternating field, with a free, damped oscillation of the circuit (20), with the free, damped oscillation resulting from the excitation by the energy pulse.

8.  The method according to claim 7, **characterized in that** the evaluating of the captured oscillation of the circuit (20) comprises a subtraction of the constant sinusoidal oscillation from the captured oscillation in order to ascertain the free, damped oscillation.

9.  The method according to claim 8, **characterized in that** the subtraction of the constant sinusoidal oscillation from the captured oscillation is carried out by means of software or by means of hardware, in particular while employing an amplifier and/or preferably by addition of a signal which corresponds to the signal captured by the calibrating antenna (310) and inverted.

10. The method according to claim 8, **characterized in that** in the evaluating step there is ascertained from the captured or ascertained free, damped oscillation of the circuit (20) the self-resonant frequency and/or the quality factor of the circuit (20) for the field strength (H) of the alternating magnetic field.

11. The method according to any of the preceding claims, **characterized in that** the method is repeated with a changed field strength (H) of the alternating magnetic field, the evaluating of the captured oscillation is effected in dependence on the field strength (H) of the alternating magnetic field in which the circuit (20) is arranged.

12. The method according to any of the preceding claims, **characterized in that** the evaluating of the captured oscillation is effected in dependence on an operating or switching state of one or more parts of the electronic component (24) that is due to the presence of the alternating magnetic field.

13. An apparatus (1000) for checking a circuit (20) devised for contactless data communication, which comprises an antenna (22) and an electronic component (24) coupled with the antenna (22), having:

    - a transmitting device (200) having a transmitting antenna (210) which is devised to generate an alternating magnetic field for a circuit (20) to be checked which is arrangeable in the measuring apparatus (1000),
    - a pulse means (110, 130) which is devised to additionally excite the circuit (20) to be checked, and
    - an evaluation means (140, 160) which is devised to evaluate an oscillation of the circuit (20) to be checked which is captured in response to the excitation by the pulse means (110, 130), wherein the apparatus (1000) is devised to maintain the alternating magnetic field while the circuit (20) is additionally excited.

14. The apparatus according to claim 13, **characterized in that** the evaluation means (160) which is connected to the measuring antenna (140) is devised to determine from the oscillation of the circuit (20) captured by the measuring antenna (140) a field strengthdependent property of the circuit (20) for the generated field strength.

15. The apparatus according to claim 13 or 14, **characterized in that** the apparatus is devised for carrying out a method according to any of claims 2 to 12.

**Revendications**

1.  Procédé d'examen d'un circuit (20) conçu pour la communication de données sans contact, lequel comprend une antenne (22) et un élément (24) électronique couplé à l'antenne (22), comprenant les étapes :

    - génération (S1) d'un champ magnétique alternatif pour le circuit (20) :
    - excitation (S3) du circuit (20) au moyen d'une impulsion d'énergie,
    - saisie (S4) d'une oscillation du circuit (20) en réponse à l'excitation par l'impulsion d'énergie ; et
    - évaluation (S5) de l'oscillation saisie du circuit (20) ;

cependant que, pendant l'excitation (S3), la génération (S1) du champ magnétique alternatif a lieu, et cependant que l'excitation du circuit (20) par l'impulsion d'énergie a lieu en présence d'un champ magnétique alternatif constant.

2. Procédé selon la revendication 1, **caractérisé par**

- agencement (S2) du circuit (20) dans la zone du champ alternatif.

3. Procédé selon la revendication 1 ou 2, **caractérisé en ce que** l'excitation (S3) du circuit a lieu sous forme d'excitation inductive au moyen d'un champ magnétique pulsé, cependant que le champ magnétique est de préférence généré par une impulsion individuelle de courant.

4. Procédé selon la revendication 3, **caractérisé en ce que** l'impulsion de courant est générée en tant qu'impulsion de courant continu sous forme d'une impulsion de Dirac.

5. Procédé selon une des revendications précédentes, **caractérisé en ce que** l'excitation du circuit (20) est réalisée sans contact au moyen d'une bobine externe d'excitation (130) et/ou que la saisie de l'oscillation du circuit (20) est réalisée sans contact au moyen d'une bobine externe de mesure (140).

6. Procédé selon une des revendications précédentes, **caractérisé en ce que** le champ alternatif est généré au moyen d'une antenne d'émission (210) et que l'intensité de champ (H) du champ alternatif est mesurée au moyen d'une antenne de calibrage (310) afin de permettre une génération du champ magnétique conformément à une intensité de champ (H) prédéterminée, cependant que l'antenne de calibrage (310) et l'antenne (22) du circuit (20) sont de préférence agencées de telle manière relativement à l'antenne d'émission (210) que, dans la zone de l'antenne de calibrage (310) et dans la zone de l'antenne (22) du circuit (20), il y a respectivement un champ magnétique alternatif de la même intensité de champ (H).

7. Procédé selon une des revendications de 1 à 6, **caractérisé en ce que** la saisie de l'oscillation du circuit comprend une saisie d'une superposition d'une oscillation sinusoïdale du circuit (20) provoquée par le champ alternatif avec une oscillation libre amortie du circuit (20), cependant que l'oscillation libre amortie résulte de l'excitation par l'impulsion de courant.

8. Procédé selon la revendication 7, **caractérisé en ce que** l'évaluation de l'oscillation saisie du circuit (20) comprend une soustraction dans laquelle l'oscillation sinusoïdale constante est soustraite à l'oscillation saisie afin de déterminer l'oscillation libre amortie.

9. Procédé selon la revendication 8, **caractérisé en ce que** la soustraction dans laquelle l'oscillation sinusoïdale constante est soustraite à l'oscillation saisie est réalisée au moyen de logiciel ou au moyen de matériel, en particulier en utilisant un amplificateur, et/ou par addition d'un signal qui correspond au signal saisi et inversé par l'antenne de calibrage (310).

10. Procédé selon la revendication 8, **caractérisé en ce que**, lors de l'étape de l'évaluation, à partir de l'oscillation libre amortie saisie ou déterminée du circuit (20), la fréquence de résonance propre et/ou la qualité du circuit (20) pour l'intensité de champ (H) du champ magnétique alternatif est déterminée.

11. Procédé selon une des revendications précédentes, **caractérisé en ce que** le procédé est répété à une intensité de champ (H) modifiée du champ magnétique alternatif, que l'évaluation de l'oscillation saisie a lieu en fonction de l'intensité de champ (H) modifiée du champ magnétique alternatif dans lequel le circuit (20) est agencé.

12. Procédé selon une des revendications précédentes, **caractérisé en ce que** l'évaluation de l'oscillation saisie a lieu en fonction d'un état de fonctionnement ou de commutation, dû à la présence du champ magnétique alternatif, d'un ou de plusieurs composants de l'élément (24) électronique.

13. Dispositif (1000) d'examen destiné à l'examen d'un circuit (20) conçu pour la communication de données sans contact, lequel comprend une antenne (22) et un élément (24) électronique couplé à l'antenne (22), comprenant :

- un équipement émetteur (200) ayant une antenne émettrice (210) conçue pour générer un champ magnétique alternatif pour un circuit (20) à examiner agenceable dans le dispositif de mesure (1000),

- un moyen d'impulsion (110, 130) conçu pour exciter additionnellement le circuit (20) à examiner, et
- un moyen d'évaluation (140, 160) conçu pour évaluer une oscillation, saisie en réponse à l'excitation par le moyen d'impulsion (110, 130), du circuit (20) à examiner,

cependant que le dispositif (1000) est conçu pour maintenir le champ magnétique alternatif pendant que le circuit (20) est excité additionnellement.

**14.** Dispositif selon la revendication 13, **caractérisé en ce que** le moyen d'évaluation (160) relié à l'antenne de mesure (140) est conçu pour, à partir de l'oscillation du circuit (20) saisie par l'antenne de mesure (140), déterminer une propriété du circuit (20) dépendante de l'intensité de champ pour l'intensité de champ générée.

**15.** Dispositif selon la revendication 13 ou 14, **caractérisé en ce que** le dispositif est conçu pour la réalisation d'un procédé selon une des revendications de 2 à 12.

FIG 1

## FIG 2A

## FIG 2B

$$L1 = \Sigma \delta L, \quad R = \Sigma \delta L$$

## FIG 2C

# FIG 3

| Erzeugen magnetisches Wechselfeld mit Feldstärke H | ⎯S1 |

↓

| Anordnen Schaltkreis in Wechselfeld | ⎯S2 |

↓

| Anregen des Schaltkreises mittels Energiepulses | ⎯S3 |

↓

| Erfassen einer Schwingung des Schaltkreises | ⎯S4 |

↓

| Auswerten der erfassten Schwingung | ⎯S5 |

# FIG 4

$A = A_0\, e^{-\delta t}$

$A = A_0\, \exp(-\delta t)\, \cos \omega t$

FIG 5

FIG 6

EP 2 954 338 B1

## FIG 7A

## FIG 7B

# FIG 8A

Dirac-Puls

Definiertes
magnetisches
Wechselfeld

T2

Pulsantwort

# FIG 8B

| Erzeugen magnetisches Wechselfeld mit Feldstärke H | S1 |

| Anordnen Schaltkreis in Wechselfeld | S2 |

| Abschalten Wechselfeld | S2a |

| Anregen des Schaltkreis mittels Energiepulses | S3 |

| Erfassen einer Schwingung des Schaltkreises | S4 |

| Auswerten der erfassten Schwingung | S5 |

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6236220 B
- DE 10117249
- US 3659197 A

**In der Beschreibung aufgeführte Nicht-Patentliteratur**

- **VON KLAUS FINKENZELLER.** RFID-Handbuch. Carl Hanser Verlag, 2012